# EUROPEAN PATENT SPECIFICATION

(11) **EP 1 514 333 B1**
(45) Date of publication and mention of the grant of the patent: **30.08.2006**
(21) Application number: 02754623.3
(22) Date of filing: 05.06.2002
(51) Int. Cl.: H01S 3/083, H01S 5/14, H01S 5/10

(54) **WAVELENGTH TUNABLE RING-RESONATOR**
WELLENLÄNGENABSTIMMBARER RINGRESONATOR
RESONATEUR EN ANNEAU ACCORDABLE EN LONGUEUR D'ONDE

(43) Date of publication of application: 16.03.2005
(73) Proprietor: Agilent Technologies Deutschland GmbH, 71034 Böblingen (DE)
(72) Inventor: NEBENDAHL, Bernd, 71254 Ditzingen (DE)
(74) Representative: Neuerburg, Gerhard
(86) International application number: PCT/EP2002/006123
(87) International publication number: WO 2003/105293

(56) References cited:
- EP-A- 1 030 418
- EP-A- 1 202 408
- US-A- 4 292 602
- US-A- 5 265 108
- US-A- 5 351 252
- US-A- 5 377 010
- US-A- 5 651 018
- US-A- 6 160 826
- LABACHELERIE M DE ET AL: "MODE-HOP SUPPRESSION OF LITTROW GRATING-TUNED LASERS" APPLIED OPTICS, OPTICAL SOCIETY OF AMERICA,WASHINGTON, US, vol. 32, no. 3, 20 January 1993 (1993-01-20), pages 269-274, XP000334482 ISSN: 0003-6935
- LEVIN L: "Mode-hop-free electro-optically tuned diode laser" OPTICS LETTERS, 15 FEB. 2002, OPT. SOC. AMERICA, USA, vol. 27, no. 4, pages 237-239, XP002229688 ISSN: 0146-9592

## Description

### BACKGROUND OF THE INVENTION

The present invention relates to wavelength tunable lasers.

In the optical communication industry there is a need for testing e.g. optical components and amplifiers with lasers at different wavelengths. For this purpose, various types of laser cavities are known.

Tunable lasers are described e.g. as the so-called Littman geometry in "Liu and Littman, Novel geometry for single-mode scanning of tunable lasers, Optical Society of America, 1981", or as the so-called Littrow geometry in EP 0 952 643 A2. Bragg-reflector type cavities are shown e.g. in "A. Nahata et al., Widely Tunable Semiconductor Laser Using Dynamic Holographically-Defined Distributed Bragg Reflector, 2000 IEEE".

US 5,651,018 discloses a wavelength stabilized semiconductor laser having a light amplifying diode heterostructure with a flared gain region in an external cavity. Further, a frequency stabilized ring laser with an active fine adjustment of the optical path length is disclosed.

### SUMMARY OF THE INVENTION

It is an object of the present invention to provide an alternative solution for wavelength tunable lasers. The object is solved by the independent claim. Preferred embodiments are shown by the dependent claims.

According to the present invention a ring laser arrangement is adapted for providing an optical beam travelling on an optical path representing a closed loop. A laser gain medium is coupled into the optical path for amplifying the optical beam by stimulated emission. Collimating devices might be provided in case the beam provided by the laser medium is not already collimated. The ring laser further comprises a wavelength filter coupled into the optical path for providing a wavelength selection to an optical beam travelling along the optical path.

Resonance condition in the ring resonator is that the optical path length for one roundtrip along the closed loop must be an integer multiple of the resonance wavelength (e.g. in contrast to the resonance condition for end-mirror-type laser resonators, wherein the optical path length between two end mirrors must be an integer multiple of half of the wavelength). The fact that there are travelling waves in the ring resonator avoids the effect of spatial hole burning present in some laser gain media (e.g. in contrast to the standing wave in the end-mirror-type laser resonators).

In a preferred embodiment, the ring laser further comprises a length modification allowing to modify the optical path length (determined by the geometrical path length and refractive index of each element in the path) of the optical path. The length modification is preferably coupled with the wavelength filter in order to adjust and/or synchronize variations in the wavelength selection provided by the wavelength filter with the optical path length. Thus, e.g. mode hops occurring when tuning the optical beam in wavelength can be reduced or even be avoided.

Coupling between the wavelength filter and the length modification can be provided e.g. by designing the geometry of the ring laser following the principles of one of the aforementioned geometries (preferably Littman or Littrow), by applying a control unit controlling operation of the wavelength filter as well as of the length modification (preferably for providing a synchronization between both), or by combinations thereof. Such control unit might be based on a predefined parameter setting derived e.g. from previous runs of the ring laser for example to achieve substantially mode hop free tuning. Alternatively or in addition thereto, the control unit might be embodied as disclosed in the International Patent Application PCT/EP02/04736 by the same applicant.

Alternatively or in addition thereto, the control unit might directly monitor the optical beam in order to detect indications of mode hops likely to occur and to initiate appropriate counteractions in order to avoid such mode hops occurring. Such counteractions can be at least one of to adjust the optical path length to the present wavelength filter property or to adjust the wavelength filter to the present optical path length. In a preferred embodiment discussed further below, the optical path length is modulated resulting in a wavelength modulation of the corresponding optical beam in order to derive an error signal representative for a deviation of a wavelength of the optical beam (preferably the wavelength of a dominant mode) from a wavelength of the filter characteristic of the wavelength filter (preferably the wavelength of a filter extreme value e.g. a wavelength where the filter has local maximum transmission).

Without influencing the sense of direction for the optical beam travelling along the loop of the optical path, one direction might become more dominant e.g. under the influence of mode competition. For the sake of easier understanding, the more dominant direction shall be referred to in the following as the forward direction, while the less dominant direction shall be referred to in the following as the reverse direction. Accordingly, forward beam shall mean an optical beam travelling into the forward direction, while reverse beam shall mean an optical beam travelling into the reverse direction.

In case of a mode selection provided within the ring resonator and assuming same optical path lengths in the forward and reverse direction, a forward mode (i.e. a dominant mode travelling into the forward direction) and a reverse mode (i.e. a dominant mode travelling into the reverse direction) may occur, both having the same wavelength but opposite propagation directions. Under the influence of mode competition, usually one of the modes will become dominant and exhibit a significantly higher intensity than the other. Following the above naming convention, the dominant mode shall be referred to in the following as the forward mode, and the less dominant mode shall be referred to in the following as the reverse mode.

In one embodiment, a direction controller is provided into the optical path in order to have the forward mode always into the same direction (or, in other words, to define the forward direction to be in one defined direction). This can be achieved e.g. by attenuating the reverse beam with respect to the forward beam.

In one preferred embodiment, the reverse beam (preferably the reverse mode) is utilized for controlling at least one property of the forward beam. Since there is known relation between the properties of the reverse and forward beam, the reverse beam can be used for monitoring the characteristic of the forward beam, or vice versa, e.g. in order to reduce, avoid, or even provoke mode hops. Preferably, the beam less in optical power is employed for controlling purposes. For the sake of explanation here, it shall be assumed that the reverse beam is less in optical power and employed for controlling.

In one embodiment, the optical path length of the reverse mode is modulated without modulating the optical path length of the forward mode resulting in a wavelength modulation of the reverse mode only, and a control signal can be derived from resulting variations in intensity of the reverse mode. Such differences in intensity of the reverse mode result from the characteristic of the filter curve of the wavelength filter generally having at least one transmission maximum at one wavelength value and ranges over the wavelength with reducing transmission behavior. When modulating the wavelength of the reverse mode, its intensity will be modulated correspondingly by the wavelength characteristic of the wavelength filter. Using known controlling mechanisms (e.g. deriving a control or error signal from the determined deviation) thus allows controlling deviations of the wavelength of the forward mode, e.g. from the maximum in the filter characteristics of the wavelength filter. Such determined deviation might then be used e.g. to modify the optical path length in order to adjust the wavelength of a selected dominant mode (e.g. the forward mode) with the present setting of the wavelength characteristics of the wavelength filter (for example in order to avoid or reduce mode hops) or might be used e.g. to modify the maximum transmission wavelength of the wavelength filter for the same purpose.

In another embodiment, the wavelength of the reverse mode is offset with respect to the wavelength of the forward mode. This can be achieved e.g. by modifying the optical path length in the reverse direction with respect to the optical path length in the forward direction. This can be accomplished, for example, by at least partly separating the optical beams in forward and reverse direction and modifying the optical path length for at least one of the separated beams. The separation can be done spatially and the modification can be done by at least partly changing the refractive index or the geometrical path length. Additionally or alternatively, the separation can be done by using different polarizations of light at least partly but maintaining the same geometrical path for the reverse and forward beams/modes. The modification of the optical path length can then be achieved e.g. by a birefringent element in that part of the path where both modes use different polarizations. The difference in the optical path length is then given by the difference in the index of refraction for the polarizations used by the reverse and forward beams/modes.

Such wavelength offset between the forward and reverse beam/mode can then be utilized for detecting a direction of a change in the deviation of the dominant mode from a filter maximum. Preferably, the offset between the wavelength of the forward and reverse modes is selected in a way that in case the wavelength of the forward mode substantially coincides with the wavelength of the filter maximum, the (offset) wavelength of the reverse mode is selected in a range wherein the filter characteristic shows a falling or rising edge (and thus a stronger dependency on the wavelength). Thus, small variations in wavelength will be "amplified" by the falling or rising edge into the modulated or unmodulated intensity of the reverse mode, and the direction of deviation from the filter maximum can be unambiguously determined from the course of the variation in the reverse mode intensity or from the change of the ratio of the intensity of the forward and reverse mode

The ring resonator comprises two parallel-reflecting devices. Each parallel-reflecting device receives an incident beam and reflects a beam, whereby the reflected beam is substantially parallel to the incident beam but spatially separated therefrom. Each parallel-reflecting device can be provided by adequately arranging reflecting surfaces (e.g. mirrors) or combinations of lenses and mirrors, e.g. by at least two assembled plane mirrors or at least one circular or cylindrical lens and a mirror or as solid device as known in the art. For easier adjustment, a dihedral or trihedral element might be used having the advantage of providing substantially fixed surfaces with respect to each other thus allowing reducing effort for aligning the reflecting surfaces in angle with respect to each other and with respect to the beams. The dihedral or trihedral element might be a prism in which the reflection mechanism is total internal reflection at an interface where the index of refraction changes from a high to a low value and the angle of incidence is above the angle for total internal reflection. Alternatively, the dihedral or trihedral element might apply metallic or dielectric reflection as reflection mechanism to avoid that a part of the optical path has to be inside a material with a high index of refraction. In another preferred embodiment, the parallel-reflecting device can be provided as a retro-reflecting device as disclosed in the International Application No. PCT/EP02/01433 by the same applicant.

The reflecting surfaces of each parallel-reflecting device are preferably provided to be large in area with respect to incident area of the optical beam in order to ensure spatial separation between input and output beams.

In one embodiment, two parallel-reflecting devices are arranged that a beam launched from a first one of the parallel-reflecting devices is received by the second one of the parallel-reflecting devices and returned spatially separated back to the first one of the parallel-reflecting devices, thus providing the closed loop of the ring resonator. In other words, the two parallel-reflecting devices can be provided to span up the closed loop. It goes without saying that other components can be arranged within such provided loop.

The wavelength filter is arranged within the ring resonator so that the optical beam travelling one loop within the ring resonator will pass the wavelength filter twice. This can be achieved e.g. by providing both beams received on opposite sides of the wavelength filter to be substantially parallel to each other and by providing sufficiently large surfaces at the wavelength filter to receive both beams. This can be accomplished in particular when using the aforedescribed arrangement with the two parallel-reflecting devices for spanning up the loop.

One or more outputs for coupling out a portion of the laser beam within the ring resonator can be provided substantially at any place within the optical path. Preferably, one or more beam splitters can be introduced into the optical path for coupling out a portion of the laser beam. In a preferred embodiment, a portion of the forward beam is coupled out after passing the wavelength filter at least once and before returning to the laser medium. Controlling the direction of the forward beam and suppressing the reverse beam (if not provided automatically, e.g. due to mode competition) thus allows a wavelength purified beam of the wavelength filter without weakening the optical beam due to unwanted coupling out at the beam splitter in the reverse direction.

Another option for coupling out is to use a beam zeroth order provided by a diffraction grating used as wavelength filter. A further option is to provide at least one reflecting surface to be a least partly transmittive. Preferably, at least one reflecting surface of at least one of the parallel-reflecting devices might be applied for coupling out. However, preferably unmoved components are applied for coupling out in order to reduce mechanical effort.

In another preferred embodiment, the design of the ring resonator follows the principle of the aforementioned Littman architecture. In that embodiment, the wavelength filter comprises a diffraction grating. The diffracted beam from the diffraction grating is directed to an input of a first parallel-reflecting device, which will return the beam towards the diffraction grating substantially parallel to the beam from the diffraction grating but spatially separated therefrom.

The beam from the parallel-reflecting device, which is parallel to the beam received by the first parallel-reflecting device but spatially offset thereto, is directed again towards the diffraction grating diffracting the beam parallel to the beam initially received by the diffraction grating, however, with opposite propagation direction and spatially separated therefrom. A second parallel-reflecting device is arranged to receive the thus twice diffracted beam from the diffraction grating and will provide a beam parallel thereto but spatially separated therefrom towards the diffraction grating, thus closing the loop of the ring resonator.

Following the Littman geometry, rotating at least one element of the two parallel-reflecting devices and the diffraction grating around a pivot point (theoretically defined by the intersection of the optical planes provided by the two parallel-reflecting devices and the diffraction grating) thus theoretically allows to continuously tune the ring resonator in wavelength without mode hops occurring. Deviations of an actual pivot point from the theoretically defined pivot point might be compensated e.g. by modifying the filter curve for selecting modes. Such variation in the filter curve can be achieved e.g. by at least one of the following: moving a dispersion element for selecting at least one laser mode (e.g. as disclosed in the aforementioned European Patent application 01113371.7), modifying the dispersive characteristic of a dispersive element e.g. by modifying the periodicity of the dispersive element, modifying the direction of the beam incident to the dispersive element, by moving a retro-reflective dispersive element, etc.

Additionally or alternatively, deviations of an actual pivot point from the theoretically defined pivot point might be compensated e.g. by modifying the optical path length of ring resonator. This can be provided e.g. by at least one of: moving one of the cavity elements to change the geometrical length (for example by moving at least one of the parallel-reflecting devices), moving an optical element such as a wedge substantially perpendicular to the optical beam, controlling the optical path length of at least one of the cavity elements by an external parameter (such as applied electrical or magnetic field, temperature, uniaxial or hydrostatic pressure), controlling the orientation of the optical active axis by an external parameter, etc.

In another preferred embodiment, the design of the ring resonator follows the principle of the aforementioned Littrow architecture. In that embodiment, the dispersive element acts as device that reflects the incident beam into itself. In order to spatially offset the reflected beam, a preferred embodiment provides a triangular loop geometry using a slightly tilted reflection grating as dispersive element. In another embodiment, the beams are separated spatially after being reflected by the dispersive element. Alternatively, the two separated beams can be rotated (preferably Faraday rotated) by substantially π/2 with respect to each other and combined by a polarization beam combiner. After both separated beams are combined, the polarization is rotated back by substantially -π/4, and the dispersive reflective element in the Littrow geometry is applied.

The invention can be partly or entirely supported by one or more suitable software programs, which can be stored on or otherwise provided by any kind of data carrier, and which might be executed in or by any suitable data processing unit. Software programs or routines are preferably applied to calculate the deviation of the optical path length and/or selected wavelength of the wavelength selective element from the values that support mode hop free tuning and to calculate the correction values for one or more tuning element to readjust the optical path length and/or the selected wavelength of the wavelength selective element.

### BRIEF DESCRIPTION OF THE DRAWINGS

Other objects and many of the attendant advantages of the present invention will be readily appreciated and become better understood by reference to the following detailed description when considering in connection with the accompanied drawings. Features that are substantially or functionally equal or similar will be referred to with the same reference sign(s).
Figures 1A and 1B illustrate a preferred embodiment according to the present invention. Fig. 1A shows a principal top view, and Fig. 1B shows the three-dimensional arrangement from a side view, both following a preferred Littman geometry. Fig. 1C shows a parallel reflecting arrangement that might be applied when using a Littrow geometry
Figures 2A and 2B depict preferred embodiments for direction controllers.
Figure. 3 illustrates mode control using modulation or wavelength shifting.

### DETAILED DESCRIPTION OF THE INVENTION

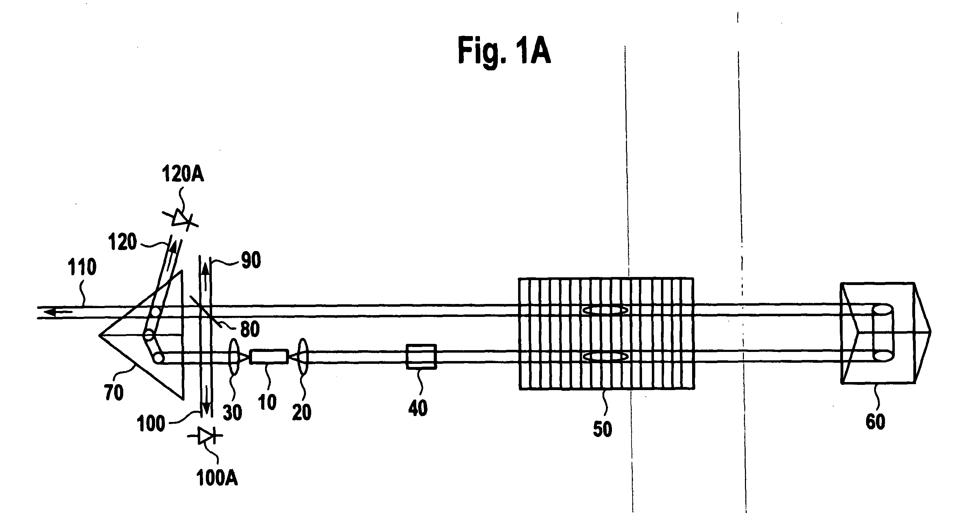

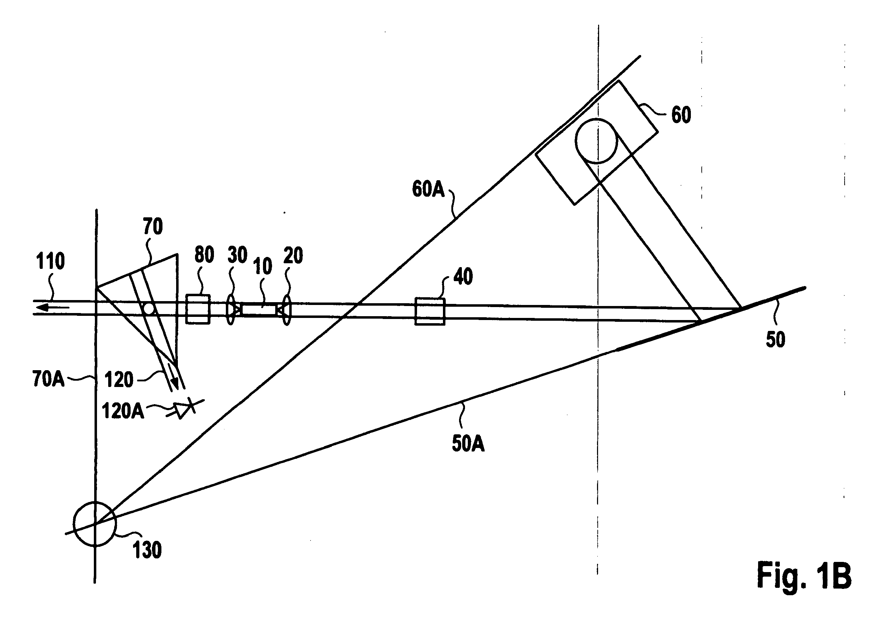

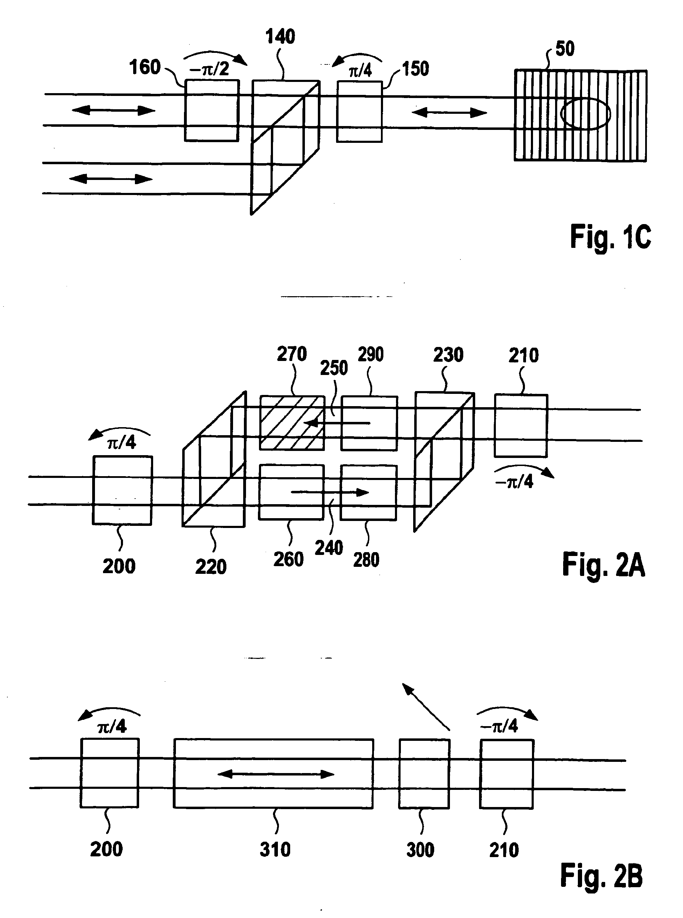

In Figures 1, a laser medium 10 emits a laser beam on each side of its end facets. The two laser beams will be collimated by collimating devices (such as lenses) 20 and 30, if the beam is not already collimated. The laser medium 10 is preferably a semiconductor laser chip but other types such as ion-doped crystals or dye cells might be applied accordingly.

The features in Figures 1 shall now be introduced with respect to a (forward) laser beam travelling (in Figure 1A) anti-clockwise (referred to as forward direction) starting from the laser medium 10. After being collimated by the collimating device 20, the beam passes an optional direction controller 40, which function will be illustrated later. After the direction controller 40, the beam impinges on a wavelength filter 50, which is embodied in Figures 1 by a diffraction grating. However, other type of wavelength filters 50 such as prisms, one-dimensional filters like etalons or birefringent filters (wherein output and input beams are substantially in one linear line), or any other dispersive element can be applied accordingly, but might require a different geometry in particular for providing continuous tunability.

The beam from the direction controller 40 is diffracted by the diffraction grating 50 and launched to a first parallel-reflecting device 60. The first parallel-reflecting device 60 receives the beam from the grating 50 and reflects a beam back toward the grating 50, whereby the reflected beam is substantially parallel to the incident beam but spatially separated therefrom. The parallel-reflecting device 60 can be embodied by various kind of arrangements of reflecting surfaces, such as a dihedral element as shown in Figures 1 or a set of plane mirrors arranged orthogonal with respect to each other.

The beam returning from the parallel-reflecting device 60 is diffracted again by the diffraction grating 50. Since both beams to and from the parallel-reflecting device 60 are substantially parallel to each other, the angles of diffraction at the grating 50 are also substantially equal, as illustrated in Figure 1B.

After being diffracted twice by the diffraction grating 50, the beam is launched to a second parallel-reflecting device 70, which can have substantially the same properties as the first parallel-reflecting device 60. The second parallel-reflecting device 70 will reflect a beam towards the laser medium 10, whereby the reflected beam is substantially parallel to the twice diffracted beam received by the second parallel-reflecting device 70 but having opposite propagation direction and being spatially separated therefrom. Thus, a closed optical loop is provided representing an optical ring resonator.

In order to couple out light from the ring resonator, various options are possible and some shall be illustrated in Figures 1. A first option is to provide an optical beam splitter 80 substantially anywhere into the optical path. Preferably in order to provide an output beam 90 having a high spectral purity, the beam splitter 80 is arranged, as shown in Figure 1A, after the beam having twice passed the wavelength filter 50 and before entering the laser medium 10 again. The portion of the output beam 90 with respect to the incident forward beam will be determined by the coupling ratio of the beam splitter 80 that designed as appropriate for the respective requirements.

In accordance with the above said, a (reverse) beam travelling clockwise (herein after referred to as reverse direction) is emitted by the laser medium 10 towards the (optional) collimating device 30, is reflected spatially separated by the second parallel-reflecting device 70, passes for a first time the wavelength filter 50, is reflected spatially separated by the first parallel-reflecting device 60, passes for a second time the wavelength filter 50, passes the direction controller 40, and is eventually focussed by the collimating device 20 back into the laser medium 10.

Accordingly, a portion of the reverse beam passing the beam splitter 80 will also be coupled out as an output beam 100 with substantial the same coupling ratio as for the forward beam.

In case the beam splitter 80 is arranged as shown in Figure 1A, the forward beam impinges the beam splitter 80 after having twice passed the wavelength filter 50 and before entering the laser medium 10 again. In contrast thereto, the reverse beam impinges the beam splitter 80 straight from the laser medium 10 before being wavelength-filtered. Thus, the forward beam can be coupled out at the beam splitter 80 having higher spectral purity but being reduced in power (with respect to power of the beam emitted by the laser medium), while the reverse beam can be coupled out at the beam splitter 80 having lower spectral purity but being not being reduced in power (with respect to power of the beam emitted by the laser medium).

Another option for coupling out light from the ring laser arrangement is to provide at least one of the surfaces of at least one of the parallel-reflecting devices 60 or 70 to be partly transmittive, as shown for one surface of the second parallel-reflecting device 70. The forward beam will lead to an output 110, while the reverse beam will lead to an output 120. It goes without saying that any other reflecting surface of the parallel-reflecting devices 60 and 70 can be provided alternatively or in addition thereto to be partly transmitted in order to couple out light from the ring resonator. However, in order to limit further effort it is preferred to couple out at components within the optical path, which are provided to be non-movable or are at least not actively operated or moved during coupling out.

Monitoring devices 100a and/or 120a can be provided in order to monitor the coupled out portion of the reverse beam.

In most cavity arrangements, normally either one of the forward or the reverse beam will become more dominant in intensity than the other. In order to achieve the dominant beam always in one propagation direction, the direction controller 40 might be introduced into the optical path. The direction controller 40 provides a different attenuation for the beams travelling in forward and reverse direction. Thus, it can be achieved that the less attenuated direction becomes more dominant. In the example of Figures 1 it shall be assumed that the forward beam will become significantly dominant over the reverse beam. Having a thus defined dominant direction in the ring resonator in particular allows to defined coupling out light with desired properties. Specifically a dominant forward beam will lead to the output 90 with high-spectral purity while the more or less "unwanted" output beam 100 at the beam splitter 80 will be significantly less than the output 90.

In another preferred embodiment the direction control is utilized to control optical properties of the dominant forward beam using the less dominant reverse beam as a control beam. Thus, properties of the reverse beam can be modified for controlling the forward beam, however, without adversely affecting optical properties of the forward beam. In one embodiment (not shown in Figures 1), the reverse beam will be modulated in wavelength in order to control a deviation of a dominant mode wavelength from a maximum wavelength of the wavelength filter 50. With such control, mode hops can be reduced or even be avoided. Known control mechanisms for deriving a deviation control signal and feeding back the control signal to synchronize mode and filter wavelength can be applied.

Figure 1C illustrates an arrangement to support the Littrow geometry. Instead of the elements 50 and 60 of Figures 1A and 1B, the elements of Figure 1C are used, while the remaining features of Figs. 1A and 1B might be applied accordingly. In this arrangement, the spatially separated beams (incident from the left of Fig. 1C) are combined to a single beam but with different polarizations. Assuming the forward beam/mode is coming from the left in the lower beam, it will be spatially shifted by a polarization beam combiner 140. Then the polarization of the forward beam/mode will be rotated by substantially π/4 by a Faraday Rotator 150. After being reflected by the wavelength selective element 50, the beam will be rotated by substantially π/4 by the Faraday Rotator 150 again. Therefore, the polarization of the beam is rotated by substantially π/2 with respect to the incident polarization. Because of that the beam will pass the polarization beam combiner 140 without offset and the polarization will be rotated back substantially -π/2 by a Faraday Rotator 160. Thus, the forward beam has passed the elements without undergoing a rotation in polarization with respect to its initial state of polarization (when coming from the left in the lower beam) but is spatially shifted thereto.

Assuming now the reverse beam coming from the left but in the upper beam, it will be rotated by substantially -π/2 by the element 160 and will pass the element 140 without spatial offset. The element 150 will rotate the polarization by substantially π/4 back again before the beam hits the wavelength selective element 50. After the beam has passed the element 150 for the second time, the polarization is again in the initial state and therefore the beam will be spatially shifted by the element 140. Thus, the reverse beam has passed the elements without undergoing a rotation in polarization with respect to its initial state of polarization (when coming from the left in the upper beam) but is spatially shifted thereto.

In one embodiment, the element 50 is provided having a polarization dependency for passing the beam in either direction. Since the state of polarization is different for the forward and reverse beam when passing the element 50, such polarization dependency can be utilized to provide attenuation different for both beams. This might be applied to provide direction control in addition or alternatively to the direction control of the direction controller 40 as illustrated below. In case of a grating used as element 50, the rulings of the grating 50 and the orientation of the element 140 can be chosen e.g. to provide an attenuation of the reverse mode.

Figure 2A illustrates a first preferred embodiment for the direction controller 40. Considering first the forward beam (incident from the left of the direction controller 40), a π/4 Faraday rotator 200 rotates the polarization of the forward beam that the forward beam is substantially (fully) transmitted (denoted by arrow 240) through a polarization beam splitter 220 without leading to a partial beam (travelling in the upper path of Fig. 2A into the direction opposite to the arrow 250) being spatially offset.

As can be seen in the representation in Fig. 2A, the polarization beam splitter 220 comprises a polarization beam splitting element (here: the lower diagonal line) for splitting up an incident beam (from the left side) in portions according to its state of polarization, and a reflecting element (here: the upper diagonal line) for directing in parallel but spatially offset with respect to each other both (partial) beams provided by the polarization beam splitting element. Beams incident from the right side will be reflected and split up accordingly.

The forward beam then might travel through a non-absorbing component 260, which might be applied for compensating the optical path length of an absorbing element 270 (in the reverse path). A next element 280, e.g. a phase modulator, might be used to slightly adjust the optical path length of the forward path in case a continuous tuning is accomplished by adjusting the optical path length. Alternatively, the element 280 might be used to fine-tune the wavelength of the forward mode in case a coarse tuning element lacks in resolution. Alternatively, it might also be applied to compensate for the optical path length of an element 290 (in the reverse path).

The forward beam (denoted by arrow 240) is then passed to a second polarization beam splitter 230 (corresponding in function to the first polarization beam splitter 220 but applied here in opposite direction) leading to a spatial offset for the forward beam travelling now in the upper path of Fig. 2A with opposite direction to arrow 250. The polarization of the forward beam is rotated back by a second -π/4 Faraday rotator 210 to maintain the polarization before passing the direction controller 40. The orientation of the polarization beam splitters 220 and 230 are designed to establish the above-described path.

The reverse beam (incident from the right of the direction controller) is transmitted through the -π/4 Faraday rotator 210. The polarization of forward and reverse beam are orthogonal between element 210 and 230, therefor the reverse beam passes the polarization beam splitter 230 in the upper path with the direction of arrow 250 (thus not leading to a spatial offset for the reverse beam).

A phase shifter 290 might be inserted for modulating the optical path length of the reverse mode (denoted by arrow 250). In addition or alternatively, an attenuation element 270 might be applied to attenuate the reverse mode in such a way the mode competition will prefer the forward mode but the reverse mode will still exist but with substantially lower optical power. It is clear that the phase modulators 290 and 280 might be omitted in case the optical path length of the forward and reverse mode only have to be different but no modulation is applied. For that purpose, the optical path lengths of elements 270 and 260 might be chosen in a way that a preferred path difference is obtained. This might be accomplished e.g. by simply omitting the element 260.

Figure 2B illustrates a second preferred embodiment for the direction controller 40, preferably applied for different optical path lengths for the reverse and forward mode. Again, the forward beam (coming from the left side) is transmitted through the π/4 Faraday rotator 200 in such a way that the output polarization is oriented along the slow or fast axis (depending on whether the forward mode should have an optical path length longer or shorter than the reverse mode) of a birefringent element 310. After passing the birefringent element 310, a polarizer 300 follows, which in oriented such that the forward mode is passed through substantially without attenuation. The -π/4 Faraday rotator 210 is utilized to again rotate back the polarization into the original orientation.

The reverse beam (coming from the right side) will be transmitted through the -π/4 Faraday rotator 210 in such a way that the orientation of the polarization between elements 210 and 300 is now oriented in the fast axis (if the forward beam was oriented in the slow axis of the birefringent element 310), or vice versa. But before travelling through the element 310, the polarizer 300 will attenuate the reverse beam because the orientation on the transmitted polarization is substantially orthogonal to the polarization of the reverse beam. The reverse beam will then be transmitted through the birefringent element 310 and the polarization will be rotated back to the incident polarization by the π/4 Faraday rotator 200. The optical path difference of the direction controller 40 can be denoted as the geometrical length of the element 310 times the difference of the indices of refraction for the slow and fast axis. Instead of the polarizer 300, any other type of dichroic element might be applied accordingly. The term dichroism shall refer to the selective absorption of one of the two orthogonal P-state components of an incident beam (see e.g. Hecht, Optics, 3^{rd} Edition, p.327).

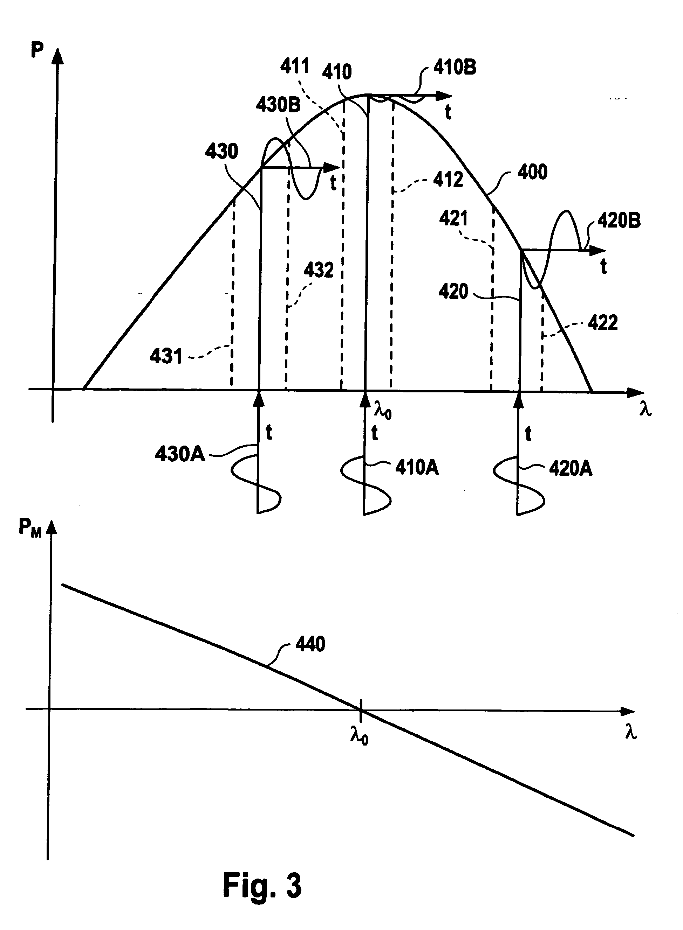

In one embodiment, the optical path length of one of the forward or the reverse path is varied with respect to the other. Thus, an offset in wavelength between modes in the forward and the reverse beam can be achieved. In a preferred embodiment, such wavelength offset is designed in a way that it can be modulated. This shall now be illustrated as an example in Figure 3. The wavelength selective element 50 shall have a characteristic shape 400 with its maximum at the wavelength λ₀. The effect of the respective position of a mode (with respect to the characteristic shape 400) on the modulation shall be depicted for three different forward modes 410, 420 and 430 of the ring resonator. The mode 410, in this example here, shall be exactly centered with respect to the maximum transmission at λ₀ of the wavelength selective element 50, while the modes 420 and 430 are offset with respect to λ₀.

Modulation of the reverse modes (410A, 420A and 430A corresponding to the forward modes 410, 420 and 430) over time between wavelength positions 411 and 412, 421 and 422, and 431 and 432, respectively, leads accordingly to a modulation of the output power of each of the reverse modes over the time (as depicted by graphs 410B, 420B and 430B).

The lower diagram in Fig. 3 illustrates an example of an amplitude of a demodulated output signal 440 of the reverse mode. The demodulated signal 440 vanishes if the center position of the modulation exactly matches the center wavelength λ₀ of the filter curve 400. Furthermore, the sign of the amplitude changes at exactly that position, and the amplitude increases monotonically with the deviation from the center wavelength. Therefore, this signal 440 can be used to control a modification of at least one of the center wavelength of the wavelength filter or the wavelength of both the reverse and forward mode e.g. in order to reduce or avoid mode-hops during operation.

In another embodiment, the wavelength of the reverse mode is shifted with respect to the wavelength of its corresponding forward mode, so that e.g. the wavelength of the reverse mode corresponding to the forward mode 410 is slightly shifted towards the position 411 or 412 (and/or the wavelength of the reverse mode corresponding to the forward mode 420 is slightly shifted towards the position 421 or 422, and/or the wavelength of the reverse mode corresponding to the forward mode 430 is slightly shifted towards the position 431 or 432). The difference between the (preferably normalized) output power (with respect to the maximum) of the corresponding forward reverse modes will yield to a shape similar to 440 and can be utilized e.g. to detect whether the forward mode is shifted to the right or left of the center wavelength λ₀. Again, the corresponding correction can be made e.g. in order to reduce or avoid mode-hops during operation. It is clear that such wavelength shift between reverse and forward mode might be applied alternatively or in addition to the aforedescribed modulation.

Returning again to Figure 1B, a preferred operation mode is illustrated. Following the aforementioned Littman architecture, a theoretically mode-hop free continuous tuning can be achieved when rotating at least either one of the parallel-reflecting devices 60 and 70 and the grating 50 around a pivot point 130 theoretically defined by the intersection of an optical plane 50a of the grating 50, an optical plane 60a of the first parallel-reflecting device 60, and an optical plane 70a of the second parallel-reflecting device 70. As explained in detail in some of the aforementioned documents, deviations of a real pivot point from the theoretically pivot point 130 can lead to mode hops during wavelength sweeps. However, adequate correction is also explained in detail in some of the aforementioned documents can be applied accordingly in particular to adjust the optical path-length or the maximum transmission wavelength of the wavelength selective element. However, considering an ideal geometry, turning at least one of the first and second parallel-reflecting devices 60 and 70 or the grating 50 around the pivot point 130 allows to continuously tune the wavelength of the optical beam without having mode hops.

Instead of following the Littman geometry, other geometries can be applied accordingly such as e.g. the afore-illustrated Littrow geometry. In case that mode hops can be tolerated, and/or the overall tuning range is limited and/or a synchronization between the characteristic of the wavelength filter 50 with the mode wavelength determined by the effective optical path length is achieved otherwise, an other architecture or geometry can be applied accordingly for tuning the wavelength of the ring resonator.

## Claims

1. A ring laser arrangement adapted for providing an optical beam travelling on an optical path representing a closed loop, the ring laser arrangement comprising:
a laser gain medium (10) coupled into the optical path for amplifying the optical beam by stimulated emission,
a wavelength filter (50) coupled into the optical path for providing a wavelength selection to the optical beam travelling along the optical path,
two parallel-reflecting devices (60, 70) each adapted to receive an incident beam and to reflect a beam in return thereto, whereby the reflected beam is substantially parallel to the incident beam but spatially separated therefrom, the two parallel-reflecting devices (60, 70) being arranged to span up the closed loop,
**characterised in that** the wavelength filter (50) is arranged such that the optical beam travelling one loop within the ring resonator will pass the wavelength filter twice.

2. The ring laser arrangement of claim 1, further comprising a length modification (60) adapted to modify the optical path length of the optical path.

3. The ring laser arrangement of claim 2, wherein the length modification (60) is coupled with the wavelength filter (50) in order to adjust and/or synchronize variations in the wavelength selection provided by the wavelength filter with the optical path length.

4. The ring laser arrangement of claim 3, wherein the coupling between the wavelength filter (50) and the length modification (60) is provided by designing the geometry of the ring laser following the principles of one of the Littman or Littrow geometry.

5. The ring laser arrangement of claim 3 or any one of the above claims, wherein the coupling between the wavelength filter (50) and the length modification (60) is provided by applying a control unit controlling operation of the wavelength filter (50) as well as of the length modification (60).

6. The ring laser arrangement of claim 5, wherein the controlling of the control unit is based on a predefined parameter setting derived from previous runs of the ring laser to achieve substantially mode hop free tuning.

7. The ring laser arrangement of claim 5 or any one of the above claims, wherein the control unit directly monitors the optical beam in order to detect indications of mode hops likely to occur and to initiate a counteraction in order to avoid such mode hops occurring.

8. The ring laser arrangement of claim 7, wherein the counteraction is at least one of: to adjust the optical path length to the present wavelength filter property, or to adjust the wavelength filter to the present optical path length.

9. The ring laser arrangement of claim 1 or any one of the above claims, further comprising:
a modulator adapted for modulating the optical path length resulting in a wavelength modulation of the corresponding optical beam,
a signal analysis unit adapted to derive an error signal representative for a deviation of a wavelength of the optical beam from a wavelength of the filter characteristic of the wavelength filter (50), preferably the wavelength of a filter extreme value such as a local maximum transmission.

10. The ring laser arrangement of claim 1 or any one of the above claims, further comprising a direction controller (40) coupled into the optical path in order to provide a dominant beam travelling into a forward direction of the optical path.

11. The ring laser arrangement of claim 10, wherein the direction controller (40) attenuates a reverse beam with respect to the forward beam, the reverse beam travelling into a reverse direction opposite to the forward direction.

12. The ring laser arrangement of claim 1 or any one of the above claims, wherein a reverse beam travelling in one direction of the optical path is utilized for controlling at least one property of a forward beam travelling in an opposite direction of the optical path.

13. The ring laser arrangement of claim 12, wherein the reverse beam is used for monitoring the characteristic of the forward beam, preferably in order to reduce, avoid, or provoke mode hops.

14. The ring laser arrangement of claim 12 or any one of the above claims, wherein the reverse beam is selected as the beam less in optical power.

15. The ring laser arrangement of claim 12 or any one of the above claims, further comprising:
a modulator adapted for modulating the optical path length of the reverse beam resulting in a wavelength modulation of the reverse beam,
a signal analysis unit adapted for deriving a control signal from resulting variations in intensity of the reverse mode,
a forward control unit adapted to receive the derived control signal in order to provide a controlling of a wavelength of the forward beam based on the derived control signal.

16. The ring laser arrangement of claim 15, wherein the forward control unit is adapted to modify at least one of: the optical path length in order to adjust the wavelength of the forward beam with a present setting of the wavelength characteristics of the wavelength filter (50), or a maximum transmission wavelength of the wavelength filter, both preferably in order to avoid or reduce mode hops.

17. The ring laser arrangement of claim 15 or any one of the above claims, further comprising a wavelength offset unit adapted to offset the wavelength of the reverse beam with respect to the wavelength of the forward beam.

18. The ring laser arrangement of claim 17, wherein the wavelength offset unit is adapted to modify the optical path length in the reverse direction with respect to the optical path length in the forward direction.

19. The ring laser arrangement of claim 18, wherein the wavelength offset unit at least partly separates the optical beams in forward and reverse direction and modifies the optical path length for at least one of the separated beams.

20. The ring laser arrangement of claim 18, wherein the separation is provided by at least one of: a spatial separation, or by using different polarizations of light at least partly but maintaining the same geometrical path for the reverse and forward beams.

21. The ring laser arrangement of claim 18 or any one of the above claims, wherein the modification of the optical path length is provided by at least one of: at least partly changing the refractive index or the geometrical path length, or using a birefringent element in that part of the path where both beams have different polarizations.

22. The ring laser arrangement of claim 17 or any one of the above claims, further comprising a direction detector adapted for detecting a direction of a change in the deviation of the dominant beam from a filter maximum of the wavelength filter (50).

23. The ring laser arrangement of claim 17 or any one of the above claims, wherein the offset between the wavelength of the forward and reverse beams is selected in a way that in case the wavelength of the forward mode substantially coincides with a filter maximum wavelength of the wavelength filter, the wavelength of the reverse mode is selected in a range wherein the filter characteristic shows a stronger dependency on the wavelength.

24. The ring laser arrangement of claim 22 or any one of the above claims, wherein the direction detector is adapted for detecting a change in the direction of deviation from the filter maximum from at least one of: the course of the variation in the reverse beam intensity, or the change of the ratio of the intensity of the forward and reverse beam.

25. The ring laser arrangement of claim 1, wherein the parallel-reflecting device (60, 70) comprises at least one of: adequately arranged reflecting surfaces, combinations of lenses and reflecting surfaces, at least two assembled plane mirrors, at least one circular or cylindrical lens and a mirror, a dihedral element, a trihedral element, a prism in which the reflection mechanism is total internal reflection at an interface where the index of refraction changes from a high to a low value and the angle of incidence is above the angle for total internal reflection, and/or a retro-reflector comprising three reflecting plates, two of which being arranged in parallel and one being arranged perpendicular to the parallel plates, so that the reflected beam is parallel to the incident beam but with opposite propagation direction.

26. The ring laser arrangement of claim 1 or any one of the above claims, wherein reflecting surfaces of the parallel-reflecting device (60, 70) are provided to be large in area with respect to an incident area of the optical beam in order to ensure spatial separation between input and output beams.

27. The ring laser arrangement of claim 1 or any one of the above claims, comprising two parallel-reflecting devices (60, 70) arranged that a beam launched from a first one of the parallel-reflecting devices is received by the second one of the parallel-reflecting devices and returned spatially separated back to the first one of the parallel-reflecting devices, thus providing the closed loop of the ring resonator.

28. The ring laser arrangement of claim 1 or any one of the above claims, further comprising an output (90, 100, 110, 120) for coupling out a portion of the laser beam within the optical path of the ring resonator.

29. The ring laser arrangement of claim 28, wherein the output (90, 100, 110, 120) comprises a beam splitter (80) introduced into the optical path for coupling out a portion of the laser beam.

30. The ring laser arrangement of claim 29, wherein the beam splitter (80) is introduced into the optical path for coupling out a portion of the forward beam after passing the wavelength filter at least once and before returning to the laser medium (10).

31. The ring laser arrangement of claim 30 or any one of the above claims, wherein the output (90, 100, 110, 120) is provided by at least one of: a beam zeroth order provided by a diffraction grating used as the wavelength filter, at least one reflecting surface to be a least partly transmittive.

32. The ring laser arrangement of claim 1 or any one of the above claims, wherein the parallel-reflecting device (60, 70) comprises at least one reflecting surface for coupling out a portion of the beam traveling in the optical path.

33. The ring laser arrangement of claim 1 or any one of the above claims, wherein:
the wavelength filter comprises a diffraction grating (50),
a first diffracted beam from the diffraction grating (50) is directed to an input of a first parallel-reflecting device (60), which is adapted to provide a first returned beam towards the diffraction grating (50) substantially parallel to the first diffracted beam but spatially separated therefrom,
the first returned beam is directed towards the diffraction grating (50), diffracted thereby, and provided as a twice diffracted beam to a second parallel-reflecting device (70),
the second parallel-reflecting device (70) is arranged to receive the twice diffracted beam and to provide a beam parallel thereto but spatially separated therefrom towards the diffraction grating, thus closing the loop of the ring resonator.

34. The ring laser arrangement of claim 33, wherein at least one element of the two parallel-reflecting devices (60, 70) and the diffraction grating (50) is provided to be at least partly rotatable around a pivot point theoretically defined by the intersection of the optical planes provided by the two parallel-reflecting devices and the diffraction grating.

35. The ring laser arrangement of claim 33 or any one of the above claims, further comprising at least one compensator adapted for compensating deviations of an actual pivot point from the theoretically defined pivot point.

36. The ring laser arrangement of claim 35, wherein the compensation is provided by at least one of modifying the filter curve for selecting modes, or modifying the optical path length of ring resonator.

37. The ring laser arrangement of claim 36, wherein the variation in the filter curve is provided by at least one of the following: moving a dispersion element for selecting at least one laser mode, modifying the dispersive characteristic of a dispersive element, modifying the periodicity of the dispersive element, modifying the direction of the beam incident to the dispersive element, moving a retro-reflective dispersive element.

38. The ring laser arrangement of claim 36, wherein the modifying the optical path length is provided by at least one of the following: moving one of the cavity elements to change the geometrical length, moving at least one of the parallel-reflecting devices, moving an optical element such as a wedge substantially perpendicular to the optical beam, controlling the optical path length of at least one of the cavity elements by an external parameter, controlling the orientation of the optical active axis by an external parameter.

## Patentansprüche

1. Ringlaseranordnung, die so beschaffen ist, dass sie einen Lichtstrahl erzeugt, der sich auf einem optischen Pfad bewegt, der eine geschlossene Schleife darstellt, wobei die Ringlaseranordnung umfasst:
ein Laserverstärkungsmedium (10), das in den optischen Pfad geschaltet ist, um den Lichtstrahl durch stimulierte Emission zu verstärken;
ein Wellenlängenfilter (50), das in den optischen Pfad geschaltet ist, um eine Wellenlängenauswahl des Lichtstrahls, der sich längs des optischen Pfades bewegt, auszuführen,
zwei parallel reflektierende Einheiten (69, 70), die jeweils so beschaffen sind, dass sie einen auftreffenden Strahl empfangen und daraufhin einen Strahl reflektieren, wobei der reflektierte Strahl im Wesentlichen parallel zu dem auftreffenden Strahl, jedoch von diesem räumlich getrennt ist, wobei die beiden parallel reflektierenden Einheiten (60, 70) so angeordnet sind, dass sie die geschlossene Schleife überspannen,
**dadurch gekennzeichnet, dass**
das Wellenlängenfilter (50) so angeordnet ist, dass der Lichtstrahl, der in dem Ringresonator die Schleife einmal durchläuft, das Wellenlängenfilter zweimal durchläuft.

2. Ringlaseranordnung nach Anspruch 1, die ferner eine Längenmodifizierungseinrichtung (60) umfasst, die so beschaffen ist, dass sie die optische Pfadlänge des optischen Pfades modifiziert.

3. Ringlaseranordnung nach Anspruch 2, wobei die Längenmodifizierungseinrichtung (60) mit dem Wellenlängenfilter (50) gekoppelt ist, um Änderungen bei der Wellenlängenauswahl, die durch das Wellenlängenfilter erzeugt werden, einzustellen und/oder mit der optischen Pfadlänge zu synchronisieren.

4. Ringlaseranordnung nach Anspruch 3, wobei die Kopplung zwischen dem Wellenlängenfilter (50) und der Längenmodifizierungseinrichtung (60) realisiert wird, indem die Geometrie des Laserrings gemäß den Prinzipien der Littman-Geometrie oder der Littrow-Geometrie geschaffen wird.

5. Ringlaseranordnung nach Anspruch 3 oder einem der vorhergehenden Ansprüche, wobei die Kopplung zwischen dem Wellenlängenfilter (50) und der Längenmodifizierungseinrichtung (60) realisiert wird, indem eine Steuereinheit-Steuerungsoperation des Wellenlängenfilters (50) sowie der Längenmodifizierungseinrichtung (60) angewendet wird.

6. Ringlaseranordnung nach Anspruch 5, wobei die Steuerung der Steuereinheit auf einer im Voraus definierten Parametereinstellung basiert, die von früheren Durchläufen des Ringlasers abgeleitet ist, um eine im Wesentlichen modensprungfreie Abstimmung zu erreichen.

7. Ringlaseranordnung nach Anspruch 5 oder einem der vorhergehenden Ansprüche, wobei die Steuereinheit den Lichtstrahl direkt überwacht, um Anzeichen dafür, dass möglicherweise Modensprünge auftreten, zu erfassen und um Gegenmaßnahmen einzuleiten, um das Auftreten dieser Modensprünge zu verhindern.

8. Ringlaseranordnung nach Anspruch 7, wobei die Gegenmaßnahme wenigstens eine der folgenden Maßnahmen ist: Einstellen der optischen Pfadlänge auf die Eigenschaft des vorhandenen Wellenlängenfilters oder Einstellen des Wellenlängenfilters auf die vorhandene optische Pfadlänge.

9. Ringlaseranordnung nach Anspruch 1 oder einem der vorhergehenden Ansprüche, die ferner umfasst:
einen Modulator, der zum Modulieren der optischen Pfadlänge geeignet ist, was eine Wellenlängenmodulation des entsprechenden Lichtstrahls zur Folge hat,
eine Signalanalyseeinheit, die geeignet ist, ein Fehlersignal abzuleiten, das eine Abweichung einer Wellenlänge des Lichtstrahls von einer Wellenlänge der Filtercharakteristik des Wellenlängenfilters (50), vorzugsweise die Wellenlänge eines Filterextremwertes wie etwa eine lokale maximale Transmission darstellt.

10. Ringlaseranordnung nach Anspruch 1 oder einem der vorhergehenden Ansprüche, die ferner eine Richtungssteuereinheit (40) umfasst, die in den optischen Pfad geschaltet ist, um einen dominierenden Strahl zu erzeugen, der sich in eine Vorwärtsrichtung des optischen Pfades bewegt.

11. Ringlaseranordnung nach Anspruch 10, wobei die Richtungssteuereinheit (40) einen rückwärts gerichteten Strahl in Bezug auf den vorwärts gerichteten Strahl dämpft, wobei sich der rückwärts gerichtete Strahl in eine Rückwärtsrichtung bewegt, die der Vorwärtsrichtung entgegengesetzt ist.

12. Ringlaseranordnung nach Anspruch 1 oder einem der vorhergehenden Ansprüche, wobei ein rückwärts gerichteter Strahl, der sich in eine Richtung des optischen Pfades bewegt, für die Steuerung von wenigstens einer Eigenschaft eines vorwärts gerichteten Strahls, der sich in eine entgegengesetzte Richtung des optischen Pfades bewegt, verwendet wird.

13. Ringlaseranordnung nach Anspruch 12, wobei der rückwärts gerichtete Strahl zum Überwachen der Charakteristiken des vorwärts gerichteten Strahls verwendet wird, vorzugsweise um Modensprünge zu verringern, zu vermeiden oder auszulösen.

14. Ringlaseranordnung nach Anspruch 12 oder einem der vorhergehenden Ansprüche, wobei der rückwärts gerichtete Strahl als der Strahl mit geringerer optischer Leistung ausgewählt wird.

15. Ringlaseranordnung nach Anspruch 12 oder einem der vorhergehenden Ansprüche, die ferner umfasst:
einen Modulator, der zum Modulieren der optischen Pfadlänge des rückwärts gerichteten Strahls geeignet ist, was eine Wellenlängenmodulation des rückwärts gerichteten Strahls zur Folge hat,
eine Signalanalyseeinheit, die geeignet ist, ein Steuersignal aus den sich ergebenden Intensitätsänderungen des Rückwärtsmodus abzuleiten,
eine Vorwärtssteuereinheit, die geeignet ist, das abgeleitete Steuersignal zu empfangen, um eine Steuerung einer Wellenlänge des vorwärts gerichteten Strahls anhand des abgeleiteten Steuersignals bereitzustellen.

16. Ringlaseranordnung nach Anspruch 15, wobei die Vorwärtssteuereinheit geeignet ist, wenigstens eines von Folgendem zu modifizieren: die optische Pfadlänge, um die Wellenlänge des vorwärts gerichteten Strahls mit einer vorhandenen Einstellung der Wellenlängencharakteristiken des Wellenlängenfilters (50) einzustellen, oder die Wellenlänge einer maximalen Transmission des Wellenlängenfilters, wobei beides vorzugsweise erfolgt, um Modensprünge zu vermeiden oder zu verringern.

17. Ringlaseranordnung nach Anspruch 15 oder einem der vorhergehenden Ansprüche, die ferner eine Wellenlängenversetzungseinheit umfasst, die geeignet ist, die Wellenlänge des rückwärts gerichteten Strahls in Bezug auf die Wellenlänge des vorwärts gerichteten Strahls zu versetzen.

18. Ringlaseranordnung nach Anspruch 17, wobei die Wellenlängenversetzungseinheit geeignet ist, die optische Pfadlänge in der Rückwärtsrichtung in Bezug auf die optische Pfadlänge in der Vorwärtsrichtung zu modifizieren.

19. Ringlaseranordnung nach Anspruch 18, wobei die Wellenlängenversetzungseinheit die Lichtstrahlen in der Vorwärts- und der Rückwärtsrichtung wenigstens teilweise trennt und die optische Pfadlänge für wenigstens einen der getrennten Strahlen modifiziert.

20. Ringlaseranordnung nach Anspruch 18, wobei die Trennung durch wenigstens eines von Folgendem erzeugt wird: durch eine räumliche Trennung oder indem wenigstens teilweise unterschiedliche Polarisationen des Lichts verwendet werden, wobei jedoch der gleiche geometrische Pfad für den rückwärts gerichteten und den vorwärts gerichteten Strahl beibehalten wird.

21. Ringlaseranordnung nach Anspruch 18 oder einem der vorhergehenden Ansprüche, wobei die Modifikation der optischen Pfadlänge durch wenigstens eines von Folgendem erzeugt wird: durch eine wenigstens teilweise Änderung des Brechungsindex oder der geometrischen Pfadlänge oder durch die Verwendung eines doppelbrechenden Elements in dem Teil des Pfades, in dem beide Strahlen unterschiedliche Polarisationen aufweisen.

22. Ringlaseranordnung nach Anspruch 17 oder einem der vorhergehenden Ansprüche, die ferner einen Richtungsdetektor umfasst, der geeignet ist, die Richtung einer Änderung der Abweichung des dominierenden Strahls von einem Filtermaximum des Wellenlängenfilters (50) zu detektieren.

23. Ringlaseranordnung nach Anspruch 17 oder einem der vorhergehenden Ansprüche, wobei der Versatz zwischen der Wellenlänge des vorwärts gerichteten und des rückwärts gerichteten Strahls so ausgewählt wird, dass dann, wenn die Wellenlänge des Vorwärtsmodus mit der Wellenlänge des Filtermaximums im Wesentlichen übereinstimmt, die Wellenlänge des Rückwärtsmodus in einem Bereich gewählt wird, in dem die Filtercharakteristik eine stärkere Abhängigkeit von der Wellenlänge aufweist.

24. Ringlaseranordnung nach Anspruch 22 oder einem der vorhergehenden Ansprüche, wobei der Richtungsdetektor geeignet ist, eine Änderung der Richtung der Abweichung von dem Filtermaximum aus wenigstens einem von Folgendem zu detektieren: aus dem Verlauf der Änderung der Intensität des rückwärts gerichteten Strahls oder aus der Änderung des Verhältnisses der Intensitäten des vorwärts gerichteten und des rückwärts gerichteten Strahls.

25. Ringlaseranordnung nach Anspruch 1, wobei die parallel reflektierende Einheit (60, 70) wenigstens eines von Folgendem umfasst: in geeigneter Weise angeordnete reflektierende Oberflächen, Kombinationen von Linsen und reflektierenden Oberflächen, wenigstens zwei montierte ebene Spiegel, wenigstens eine kreisförmige oder zylindrische Linse und einen Spiegel, ein zweiflächiges Element, ein dreiflächiges Element, ein Prisma, das einen Reflexionsmechanismus mit innerer Totalreflexion an einer Grenzfläche aufweist, an der sich der Brechungsindex von einem hohen zu einem niedrigen Wert ändert und der Auftreffwinkel größer als der Winkel für innere Totalreflexion ist, und/oder ein Retro-Reflektor, der drei reflektierende Platten umfasst, wovon zwei parallel angeordnet sind und eine senkrecht zu den parallelen Platten angeordnet ist, so dass der reflektierte Strahl parallel zu dem auftreffenden Strahl, jedoch mit einer entgegengesetzten Ausbreitungsrichtung verläuft.

26. Ringlaseranordnung nach Anspruch 1 oder einem der vorhergehenden Ansprüche, wobei reflektierende Oberflächen der parallel reflektierenden Einheit (60, 70) so vorgesehen sind, dass sie einen großen Bereich in Bezug auf einen Auftreffbereich des Lichtstrahls haben, um eine räumliche Trennung zwischen eingehenden und abgehenden Strahlen sicherzustellen.

27. Ringlaseranordnung nach Anspruch 1 oder einem der vorhergehenden Ansprüche, die zwei parallel reflektierende Einheiten (60, 70) umfasst, die so angeordnet sind, dass ein Strahl, der von einer ersten Einheit der beiden parallel reflektierenden Einheiten ausgegeben wird, von der zweiten Einheit der parallel reflektierenden Einheiten empfangen und räumlich getrennt zu der ersten Einheit der parallel reflektierenden Einheiten zurückgeleitet wird, wodurch die geschlossene Schleife des Ringresonators geschaffen wird.

28. Ringlaseranordnung nach Anspruch 1 oder einem der vorhergehenden Ansprüche, die ferner in dem optischen Pfad des Ringresonators einen Ausgang (90, 100, 110, 120) zum Auskoppeln eines Teils des Laserstrahls umfasst.

29. Ringlaseranordnung nach Anspruch 28, wobei der Ausgang (90, 100, 110, 120) einen Strahlteiler (80) umfasst, der in den optischen Pfad eingesetzt ist, um einen Teil des Laserstrahls auszukoppeln.

30. Ringlaseranordnung nach Anspruch 29, wobei der Strahlteiler (80) in den optischen Pfad eingesetzt ist, um einen Teil des vorwärts gerichteten Strahls auszukoppeln, nachdem er das Wellenlängenfilter wenigstens einmal durchlaufen hat und bevor er zum Lasermedium (10) zurückkehrt.

31. Ringlaseranordnung nach Anspruch 30 oder einem der vorhergehenden Ansprüche, wobei der Ausgang (90, 100, 110, 120) bereitgestellt wird durch wenigstens eines von Folgendem: durch einen Strahl nullter Ordnung, der durch ein Beugungsgitter erzeugt wird, das als das Wellenlängenfilter verwendet wird, oder durch wenigstens eine reflektierende Oberfläche, die wenigstens teilweise durchlässig ist.

32. Ringlaseranordnung nach Anspruch 1 oder einem der vorhergehenden Ansprüche, wobei die parallel reflektierende Einheit (60, 70) wenigstens eine reflektierende Oberfläche umfasst, um einen Teil des Strahls, der sich in dem optischen Pfad bewegt, auszukoppeln.

33. Ringlaseranordnung nach Anspruch 1 oder einem der vorhergehenden Ansprüche, wobei:
das Wellenlängenfilter ein Beugungsgitter (50) umfasst,
ein erster gebeugter Strahl von dem Beugungsgitter (50) zu einem Eingang einer ersten parallel reflektierenden Einheit (60) gerichtet ist, die so beschaffen ist, dass sie einen ersten zurückgeführten Strahl zu dem Beugungsgitter (50) im Wesentlichen parallel zu dem ersten gebeugten Strahl, jedoch von diesem räumlich getrennt bereitstellt,
der erste zurückgeführte Strahl auf das Beugungsgitter (50) gerichtet ist, von diesem gebeugt wird und als ein zweifach gebeugter Strahl an eine zweite parallel reflektierende Einheit (70) bereitgestellt wird,
die zweite parallel reflektierende Einheit (70) so angeordnet ist, dass sie den zweifach gebeugten Strahl empfängt und einen dazu parallelen, jedoch davon räumlich getrennten Strahl zum Beugungsgitter (50) bereitstellt und **dadurch** die Schleife des Ringresonators schließt.

34. Ringlaseranordnung nach Anspruch 33, wobei wenigstens ein Element der beiden parallel reflektierenden Einheiten (60, 70) und des Beugungsgitters (50) so vorgesehen ist, dass es wenigstens teilweise um einen Schwenkpunkt drehbar ist, der durch den Schnittpunkt der optischen Ebenen theoretisch definiert ist, die durch die beiden parallel reflektierenden Einheiten (60, 70) und das Beugungsgitter (50) geschaffen werden.

35. Ringlaseranordnung nach Anspruch 33 oder einem der vorhergehenden Ansprüche, die ferner wenigstens eine Ausgleichseinrichtung umfasst, die geeignet ist, Abweichungen eines tatsächlichen Schwenkpunkts von dem theoretisch definierten Schwenkpunkt auszugleichen.

36. Ringlaseranordnung nach Anspruch 35, wobei der Ausgleich durch wenigstens eines vom Folgendem geschaffen wird: durch Modifizieren der Filterkurve zum Auswählen von Moden oder durch Modifizieren der optischen Pfadlänge des Ringresonators.

37. Ringlaseranordnung nach Anspruch 36, wobei die Änderung an der Filterkurve durch wenigstens eines von Folgendem geschaffen wird: durch Bewegen eines Dispersionselements zum Auswählen wenigstens eines Lasermodus, durch Modifizieren der Dispersionseigenschaft eines Dispersionselements, durch Modifizieren der Periodizität des Dispersionselements, durch Modifizieren der Richtung des Strahls, der auf das Dispersionselement auftrifft, durch Bewegen eines retroreflektierenden Dispersionselements.

38. Ringlaseranordnung nach Anspruch 36, wobei das Modifizieren der optischen Pfadlänge durch wenigstens eines von Folgendem geschaffen wird: durch Bewegen von einem der Hohlraumelemente, um die geometrische Länge zu ändern, durch Bewegen von wenigstens einer der parallel reflektierenden Einheiten, durch Bewegen eines optischen Elements wie etwa ein Graukeil im Wesentlichen senkrecht zum Lichtstrahl, durch Steuern der optischen Pfadlänge von wenigstens einem der Hohlraumelemente durch einen externen Parameter, durch Steuern der Ausrichtung der optischen aktiven Achse durch einen externen Parameter.

## Revendications

1. Un agencement laser en anneau, adapté pour fournir un faisceau optique se déplaçant sur un chemin optique, représentant une boucle fermée, l'agencement laser en anneau comprenant :
un milieu à gain laser (10), couplé dans le chemin optique, pour amplifier le faisceau optique par une émission stimulée,
un filtre de longueur d'onde (50), couplé dans le chemin optique pour fournir une sélection de longueur d'onde au faisceau optique se déplaçant le long du chemin optique,
deux dispositifs à réflexion parallèle (60, 70), chacun adapté pour recevoir un faisceau incident et pour refléter un faisceau en retour à celui-ci, de manière que le faisceau reflété soit sensiblement parallèle au faisceau incident, mais spatialement séparé de celui-ci, les deux dispositifs de réflexion parallèle (60, 70) étant agencés pour couvrir la boucle fermée,
**caractérisé en ce que** le filtre de longueur d'onde (50) est agencé de manière que le faisceau optique, se déplaçant sur une boucle dans le résonateur en anneau, passe à deux reprises par le filtre de longueur d'onde.

2. L'agencement laser en anneau selon la revendication 1, comprenant en outre une modification de longueur (60), adaptée pour modifier la longueur du chemin optique.

3. L'agencement laser en anneau selon la revendication 2, dans lequel la modification de longueur (60) est couplée au filtre de longueur d'onde (50), afin d'ajuster et/ou de synchroniser des variations dans la sélection de longueur d'onde, fournie par le filtre de longueur d'onde, avec la longueur de chemin optique.

4. L'agencement laser en anneau selon la revendication 3, dans lequel le couplage, entre le filtre de longueur d'onde (50) et la modification de longueur (60), est fourni par conception de la géométrie du laser en anneau, de façon à suivre les principes d'une géométrie, parmi la géométrie de Littman ou de Littrow.

5. L'agencement laser en anneau selon la revendication 3 ou l'une quelconque des revendications précédentes, dans lequel le couplage, entre le filtre de longueur d'onde (50) et la modification de longueur (60), est fourni par application à une unité de commande d'une opération de commande du filtre de longueur d'onde (50), ainsi que de la modification de longueur (60).

6. L'agencement laser en anneau selon la revendication 5, dans lequel la commande de l'unité de commande est basée sur un réglage de paramètre prédéfini, dérivé de divers passages du laser en anneau, pour obtenir un accord sensiblement exempt de sauts de mode.

7. L'agencement laser en anneau selon la revendication 5 ou l'une quelconque des revendications précédentes, dans lequel l'unité de commande surveille directement le faisceau optique, afin de détecter des indications de sauts de mode susceptibles de se produire et de lancer une action contraire, afin d'éviter que de tels sauts de mode se produisent.

8. L'agencement laser en anneau selon la revendication 7, dans lequel l'action contraire est au moins l'une parmi : l'ajustement de la longueur de chemin optique à la présente propriété du filtre de longueur d'onde, ou l'ajustement du filtre de longueur d'onde à la présente longueur du chemin optique.

9. L'agencement laser en anneau selon la revendication 1 ou l'une quelconque des revendications précédentes, comprenant en outre :
un modulateur, adapté pour moduler la longueur de chemin optique donnant une modulation de longueur d'onde du faisceau optique correspondant,
une unité d'analyse de signal, adaptée pour dériver un signal d'erreur, représentatif d'un écart de longueur d'onde du faisceau optique par rapport à une longueur d'onde du filtre caractéristique du filtre de longueur d'onde (50), de préférence la longueur d'onde d'une valeur extrême de filtre, telle qu'une transmission locale maximale.

10. L'agencement laser en anneau selon la revendication 1 ou l'une quelconque des revendications précédentes, comprenant en outre un contrôleur de direction (40), couplé dans le chemin optique, afin de fournir un faisceau dominant, cheminant dans une direction aller du chemin optique.

11. L'agencement laser en anneau selon la revendication 10, dans lequel le contrôleur de direction (40) atténue un faisceau de retour par rapport au faisceau aller, le faisceau de retour cheminant dans une direction de retour, opposée à la direction aller.

12. L'agencement laser en anneau selon la revendication 1 ou l'une quelconque des revendications précédentes, dans lequel un faisceau de retour cheminant dans un sens du chemin optique est utilisé pour commander au moins correctement un faisceau aller, cheminant dans un sens opposé du chemin optique.

13. L'agencement laser en anneau selon la revendication 12, dans lequel le faisceau de retour est utilisé pour surveiller la caractéristique du faisceau aller, de préférence pour réduire, éviter, ou provoquer, des sauts de mode.

14. L'agencement laser en anneau selon la revendication 12 ou l'une quelconque des revendications précédentes, dans lequel le faisceau de retour est sélectionné comme étant le faisceau à moindre puissance optique.

15. L'agencement laser en anneau selon la revendication 12 ou l'une quelconque des revendications précédentes, comprenant en outre :
un modulateur, adapté pour moduler la longueur de chemin optique du faisceau de retour, donnant une modulation de longueur d'onde du faisceau de retour,
une unité d'analyse de signal, adaptée pour dériver un signal de commande à partir de variations résultantes en intensité du mode de retour,
une unité de commande de progression, adaptée pour recevoir le signal de commande dérivé, afin de fournir une commande d'une longueur d'onde du faisceau aller, d'après le signal de commande dérivé.

16. L'agencement laser en anneau selon la revendication 15, dans lequel l'unité de commande aller est adaptée pour modifier au moins l'une de : la longueur de chemin optique pour ajuster la longueur d'onde du faisceau aller avec un réglage actuel des caractéristiques de longueur d'onde du filtre de longueur d'onde (50), ou une longueur d'onde de transmission maximale du filtre de longueur d'onde, les deux de préférence afin d'éviter ou de réduire des sauts de mode.

17. L'agencement laser en anneau selon la revendication 15 ou l'une quelconque des revendications précédentes, comprenant en outre une unité à décalage de longueur d'onde adaptée pour décaler la longueur d'onde du faisceau retour par rapport à la longueur d'onde du faisceau aller.

18. L'agencement laser en anneau selon la revendication 17, dans lequel l'unité à décalage de longueur d'onde est adaptée pour modifier la longueur de chemin optique dans le sens retour par rapport à la longueur de chemin optique dans le sens aller.

19. L'agencement laser en anneau selon la revendication 18, dans lequel l'unité à décalage de longueur d'onde sépare au moins partiellement les faisceaux optiques en sens aller et retour, et modifie la longueur de chemin optique pour au moins l'un des faisceaux séparés.

20. L'agencement laser en anneau selon la revendication 18, dans lequel la séparation est fournie par au moins l'un parmi une séparation spatiale, ou en utilisant des polarisations de lumière différentes au moins partiellement, mais en maintenant le même chemin géométrique pour les faisceaux retour et aller

21. L'agencement laser en anneau selon la revendication 18 ou l'une quelconque des revendications précédentes, dans lequel la modification de chemin optique est fournie par au moins l'un parmi : une modification au moins partielle de l'indice de réfraction de la longueur de chemin optique, ou l'utilisation d'un élément biréfringent dans la partie du chemin à laquelle les deux faisceaux ont des polarisations différentes.

22. L'agencement laser en anneau selon la revendication 17 ou l'une quelconque des revendications précédentes, comprenant en outre un détecteur de direction, adapté pour détecter une direction ou un changement dans l'écart du faisceau dominant, par rapport à un maximum de filtrage du filtre de longueur d'onde (50).

23. L'agencement laser en anneau selon la revendication 17 ou l'une quelconque des revendications précédentes, dans lequel le décalage entre la longueur d'onde des faisceaux aller et retour est sélectionné de manière que, en cas de coïncidence sensible de la longueur d'onde du mode aller avec une longueur d'onde maximale dé filtre du filtre de longueur d'onde, la longueur d'onde du mode retour soit sélectionnée dans une fourchette dans laquelle la caractéristique de filtre présente une plus forte dépendance envers la longueur d'onde.

24. L'agencement laser en anneau selon la revendication 22 ou l'une quelconque des revendications précédentes, dans lequel le détecteur de direction est adapté pour détecter un changement dans la direction de l'écart par rapport au maximum de filtre, parmi au moins l'un des éléments ci-après : l'évolution de la variation de l'intensité de faisceau retour, ou le changement du rapport de l'intensité de faisceau aller et de faisceau retour.

25. L'agencement laser en anneau selon la revendication 1, dans lequel le dispositif à réflexion parallèle (60, 70) comprend au moins l'un parmi : des surfaces réfléchissantes agencées de façon adéquate, des combinaisons de lentilles et de surfaces réfléchissantes, au moins deux miroirs plan assemblés, au moins une lentille, circulaire ou cylindrique, et un miroir, un élément dihédrique, un élément trihédrique, un prisme dans lequel le mécanisme de réflexion est une réflexion interne totale à une interface à laquelle l'indice de réfraction change d'une valeur haute à une valeur faible, et l'angle d'incidence est supérieur à l'angle pour la réflexion totale interne, et/ou un rétro-réflecteur, comprenant trois plaques réfléchissantes, dont deux sont agencées en parallèle et l'une est agencée perpendiculairement aux plaques parallèles, de manière que le faisceau réfléchi soit parallèle au faisceau incident mais avec un sens de propagation opposé.

26. L'agencement laser en anneau selon la revendication 1 ou l'une quelconque des revendications précédentes, dans lequel des surfaces réfléchissantes du dispositif à réflexion parallèle (60, 70) sont prévues pour être d'une grande aire par rapport à une aire incidente du faisceau optique afin d'assurer une séparation spatiale, entre les faisceaux d'entrée et de sortie.

27. L'agencement laser en anneau selon la revendication 1 ou l'une quelconque des revendications précédentes, comprenant deux dispositifs à réflexion parallèle (60, 70), agencés de manière qu'un faisceau, lancé d'un premier des dispositifs à réflexion parallèle soit reçu par le deuxième des dispositifs à réflexion parallèle et retourné spatialement séparément vers le premier des dispositifs à réflexion parallèle, en fournissant ainsi la boucle fermée du résonateur en anneau.

28. L'agencement laser en anneau selon la revendication 1 ou l'une quelconque des revendications précédentes, comprenant en outre une sortie (90, 100, 110, 120), pour découplage d'une partie du faisceau laser dans le chemin optique du résonateur en anneau.

29. L'agencement laser en anneau selon la revendication 28, dans lequel la sortie (90, 100, 110, 120) comprend un diviseur de faisceau (80), introduit dans le chemin optique pour découplage d'une partie du faisceau laser.

30. L'agencement laser en anneau selon la revendication 29, dans lequel le diviseur de faisceau (80) est introduit dans le chemin optique pour découplage d'une partie du faisceau aller, après passage au moins une fois dans le filtre de longueur d'onde et avant de retourner au milieu laser (10).

31. L'agencement laser en anneau selon la revendication 20 ou l'une quelconque des revendications précédentes, dans lequel la sortie (90, 100, 110, 120) est fournie par au moins l'un parmi : un ordre zéro de faisceau, fourni par un réseau de diffraction utilisé comme filtre de longueur d'onde, au moins une surface réfléchissant, devant être au moins partiellement transmissive.

32. L'agencement laser en anneau selon la revendication 1 ou l'une quelconque des revendications précédentes, dans lequel le dispositif à réflexion parallèle (60, 70) comprend au moins une surface réfléchissante, pour découpler une partie du faisceau cheminant dans le chemin optique.

33. L'agencement laser en anneau selon la revendication 1 ou l'une quelconque des revendications précédentes, dans lequel :
le filtre de longueur d'onde comprend un réseau à diffraction (50),
un premier réseau diffracté, issu du réseau de diffraction (50), est dirigé vers une entrée d'un premier dispositif à réflexion parallèle (60), adapté pour fournir un premier faisceau retourné vers le réseau de diffraction (50), sensiblement parallèlement au premier faisceau diffracté, mais spatialement séparé de celui-ci,
le premier faisceau retourné est dirigé vers le réseau de diffraction (50), est diffracté de cette manière, et fourni, en tant que faisceau ayant subi une diffraction double, à un deuxième dispositif à réflexion parallèle (70),
le deuxième dispositif à réflexion parallèle (70) est agencé pour recevoir le faisceau ayant subi une diffraction double et pour fournir un faisceau, lui étant parallèle mais spatialement séparé, vers le réseau de diffraction, fermant ainsi la boucle du résonateur en anneau.

34. L'agencement laser en anneau selon la revendication 33, dans lequel au moins un élément des deux dispositifs à réflexion parallèle (60, 70) et le réseau de diffraction (50) sont prévus pour pouvoir au moins partiellement tourner autour d'un point de pivotement, défini théoriquement par l'intersection des plans optiques fournis par les deux dispositifs à réflexion parallèle et le réseau de diffraction.

35. L'agencement laser en anneau selon là revendication 33 ou l'une quelconque des revendications précédentes, comprenant en outre au moins un compensateur, adapté pour compenser des écarts d'un point de pivotement réel par rapport au point de pivotement défini théoriquement.

36. L'agencement laser en anneau selon la revendication 35, dans lequel la compensation est fournie par au moins l'un parmi : la modification de la courbe de filtrage pour des modes de sélection, ou la modification de la longueur de chemin optique du résonateur en anneau.

37. L'agencement laser en anneau selon la revendication 36, dans lequel la variation de la courbe de filtrage est fournie par au moins l'une des possibilités suivantes : déplacement d'un élément de dispersion pour sélectionner au moins un mode laser, modification de la caractéristique de dispersion d'un élément dispersif, modification de la périodicité de l'élément dispersif, modification de la direction du faisceau indicent à l'élément dispersif, déplacement d'un élément dispersif rétro-réfléchissant.

38. L'agencement laser en anneau selon la revendication 36, dans lequel la modification de la longueur de chemin optique est fournie par au moins l'une des possibilités suivantes déplacement d'un des éléments à cavité pour modifier la longueur géométrique, déplacement d'au moins l'un des dispositifs de réflexion parallèle, déplacement d'un élément optique, tel qu'un coin, sensiblement perpendiculairement au faisceau optique, commande de la longueur de chemin optique d'au moins l'un des éléments à cavité, par un paramètre externe, commande de l'orientation de l'axe optique actif, par un paramètre externe.
